# EUROPEAN PATENT SPECIFICATION

(11) **EP 1 332 241 B1**
(45) Date of publication and mention of the grant of the patent: **03.09.2008**
(21) Application number: 01977216.9
(22) Date of filing: 26.09.2001
(51) Int. Cl.: C23C 16/00, C23F 1/02, H01L 21/00

(54) **ELECTROSTATICALLY CLAMPED EDGE RING FOR PLASMA PROCESSING**
ELEKTROSTATISCH FESTGEKLEMMTER RANDRING FÜR DIE PLASMAVERARBEITUNG
ANNEAU DE BORDURE FIXE PAR ELECTROSTATIQUE POUR LE TRAITEMENT AU PLASMA

(30) Priority: 06.10.2000 US 680515
(43) Date of publication of application: 06.08.2003
(73) Proprietor: LAM RESEARCH CORPORATION, Fremont, CA 94538-6401 (US)
(72) Inventor: HUBACEK, Jerome S., Fremont, CA 94539 (US)
(74) Representative: Brookes Batchellor LLP
(86) International application number: PCT/US2001/030286
(87) International publication number: WO 2002/031219

(56) References cited:
- WO-A-01/01445
- DE-U1- 29 813 326
- JP-A- 6 124 998
- JP-A- 2000 173 988
- KR-A- 20000 022 645
- KR-A- 20000 057 984
- US-A- 5 494 523
- US-A- 5 740 009
- US-A- 5 805 408
- US-A- 5 998 932
- US-A- 6 022 809

## Description

### Field of the Invention

The present invention relates to an improved apparatus and method for plasma processing and, in particular, an improved apparatus and method for plasma etching semiconductor substrates.

### Background of the Invention

In the field of semiconductor processing, vacuum processing chambers are generally used for etching and chemical vapor deposition (CVD) of materials on substrates by supplying an etching or deposition gas to the vacuum chamber and application of an RF field to the gas to energize the gas into a plasma state. Examples of parallel plate, transformer coupled plasma (TCP^{™}) which is also called inductively coupled plasma (ICP), and electron-cyclotron resonance (ECR) reactors and components thereof are disclosed in commonly owned U.S. Patent Nos. 4,340,462; 4,948,458; 5,200,232 and 5,820,723. U.S. Patent No. 4,793,975 also discloses a parallel plate plasma reactor.

During processing of semiconductor substrates, the substrates are typically held in place within the vacuum chamber on substrate holders by mechanical clamps and electrostatic clamps (ESC). Examples of such clamping systems and components thereof can be found in commonly owned U.S. Patent Nos. 5,262,029 and 5,838,529. An example of a monopolar chuck can be found in U.S. patent No. 4,665,463 and examples of bipolar chucks can be found in U.S. Patent Nos. 4,692,836 and 5,055,964. In order to cool the substrates, cooling gas such as helium can be supplied to the backside of the substrate. Examples of such cooling can be found in U.S. Patent Nos. 5,160,152; 5,238,499; and 5,350,479.

Substrate supports can include consumable (sacrificial) edge rings around the substrate for purposes of confining plasma to the area above the wafer and/or protect the ESC from erosion by the plasma. For instance, an edge ring arrangement is described in commonly owned U.S. Patent Nos. 5,805,408, 5,998,932 and 6,013,984. Other examples of edge ring arrangements can be found in U.S. Patent Nos. 5,494,523; 5,986,874; 6,022,809; 6,096,161; and 6,117,349.

The reader is also referred to JP 06 124998.

In plasma processing arrangements wherein a sacrificial ring surrounds a wafer, it would be desirable to improve the thermal contact between the ring and an underlying portion of the substrate support. By improving thermal coupling, improved temperature control of the ring could be realized and the clearances required between the ring and the wafer could be reduced. It would also be desirable if the RF impedance path from the baseplate to the plasma in the area above the wafer could be more closely matched to the RF impedance path from the baseplate to the plasma in the area of the edge ring in order to improve plasma uniformity near the edge of the wafer.

### Summary of the Invention

According to a first aspect of invention there is provided a coupling ring assembly adapted to surround a substrate support in a plasma reaction chamber. The coupling ring assembly comprises a member having an annular support surface, an electrostatic ring chuck on the support surface, and an edge ring on the electrostatic ring chuck dimensioned so as to provide a clearance gap between a lower surface of a substrate located on the substrate support and an upper surface of the edge ring.

According to a second aspect of the invention, there is provided an edge ring clamping assembly adapted to surround a substrate support in the plasma reaction chamber, the edge ring clamping assembly comprising: a member having an annular support surface; an electrostatic edge ring chuck on the annular support surface; and an edge ring on he edge ring chuck dimensioned so as to provide a clearance gap between a lower surface of a substrate located on the substrate support and an upper surface of the edge ring.

According to a third aspect of the invention, there is provided a method of treating a semiconductor substrate, according to claim 19.

### Brief Description of the Drawings

FIGURE 1 is a partial view of a parallel plate plasma processing apparatus according to the present invention;
FIGURE 2 is a partial view of a plasma chamber comprising an edge ring chuck mounted on a coupling ring according to one embodiment of the present invention;
FIGURE 3 is a partial view of a plasma chamber comprising an edge ring chuck mounted on a baseplate according to another embodiment of the present invention;
FIGURE 4 is a partial view of a plasma chamber according to the invention comprising an integral edge ring/wafer chuck mounted on a baseplate; and
FIGURE 5 is a partial view of a plasma chamber according to another embodiment of the invention comprising an edge ring adapted to fit into a groove in the baseplate between the wafer and edge ring chucks.

### Detailed Description of the Preferred Embodiments

The invention provides an improved substrate support arrangement for a plasma reactor wherein a sacrificial edge ring surrounds a semiconductor substrate such as a silicon wafer. In arrangements wherein an edge ring merely rests on the underlying substrate support and is held in place by gravity and/or frictional engagement with the substrate support, the ring can become very hot during plasma processing of the substrate. In the case where the substrate overlies a portion of the edge ring, the thermal expansion of the edge ring during plasma processing makes it necessary to provide sufficient clearance between the edge ring and the substrate so that the hot edge ring does not lift the substrate off of the substrate support. In the case where an electrostatic chuck is used to secure the substrate to a substrate support comprising a powered electrode which supplies an RF bias to the substrate, the RF impedance path from the powered electrode through the ESC and substrate to the plasma can be different than the RF impedance path from an outer portion of the powered electrode through the edge ring to the plasma and thus cause a nonuniform plasma density at the edge of the substrate The invention overcomes such problems by providing an electrostatic edge ring chuck which improves thermal coupling of the edge ring to the substrate support. In addition, by selecting materials for the edge ring chuck and edge ring according to the invention, it is possible to provide more uniformity of the plasma density across the substrate due to improved RF impedance path matching.

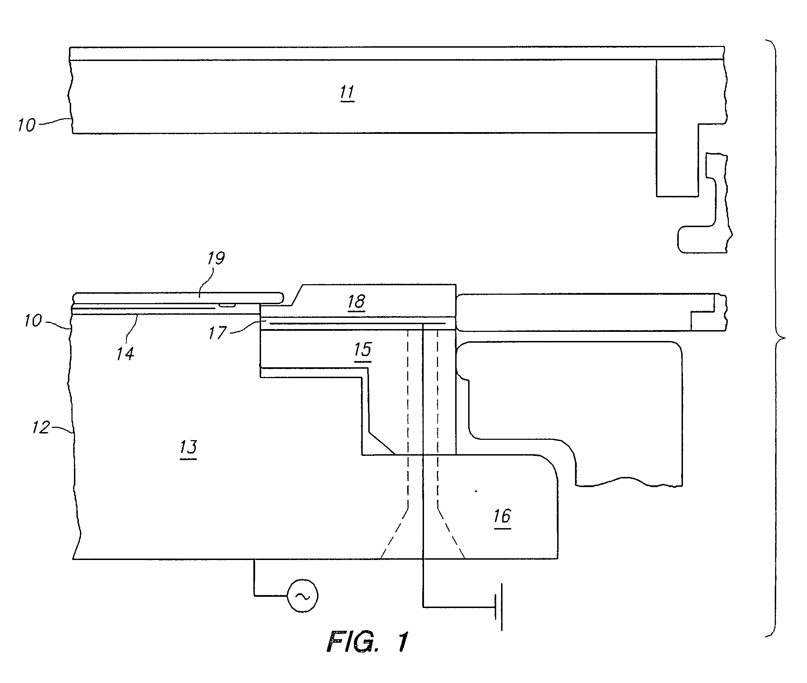

FIGURE 1 shows a parallel plate plasma reaction chamber 10 according to one embodiment the invention. The apparatus comprises an upper electrode 11 and a lower electrode assembly 12. The lower electrode assembly comprises a baseplate 13 and an electrostatic wafer chuck 14 mounted on an upper surface thereof. A coupling ring 15 rests on a flange 16 of the baseplate. The coupling ring 15 has an edge ring chuck 17 mounted on an upper surface thereof. An edge ring 18 is supported on the exposed upper surface of the edge ring chuck 17. A wafer 19 is mounted on the wafer chuck 14 such as to overlap the wafer chuck and the inner surface of the edge ring 18. The wafer 19 overlaps the edge of the wafer chuck so that the exposure of the edge of the wafer chuck 14 to the ions in the plasma is reduced. The exposure of the edges of the wafer chuck 14 to the plasma can cause erosion thereby reducing the life of the chuck 14. An edge ring 18 surrounds the wafer chuck 14 to further protect the edges of the wafer chuck 14 from ions in the plasma. The edge ring 18 is a consumable or replaceable part. The wafer 19 overhangs the wafer chuck 14 and a portion of the edge ring 18 extends under the edge of the wafer 19. Typically, the wafer 19 overhangs the edge of the wafer chuck 14 by 1 to 2 mm. In order to provide a greater degree of protection to the wafer chuck 14, the top of the edge ring 18 is positioned as closely as possible to the underside of the wafer 19. The expansion of the edge ring during processing requires a clearance gap between the underside of the wafer and the edge ring. If the edge ring is placed too close to the wafer backside, the thermal expansion of the edge ring during processing can actually force the wafer off of the chuck, aborting the process.

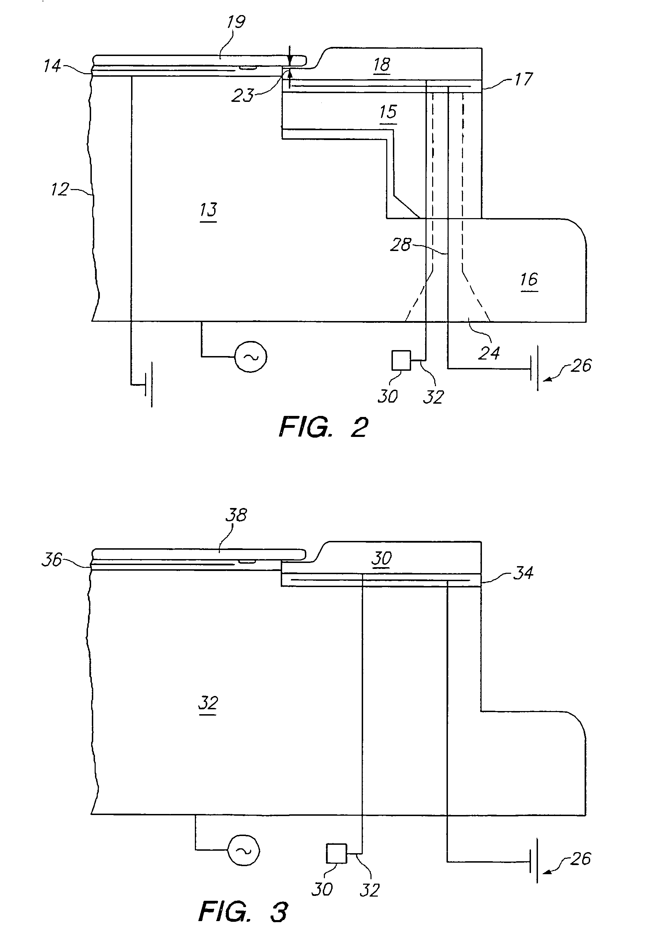

FIGURE 2 is an enlarged view of the lower electrode assembly 12 of FIGURE 1. The wafer 19 is shown overlapping the edge ring 18 to form a gap or clearance 23 between the wafer backside and the edge ring 18. The inner edge of the edge ring 18 abuts the outer edge of the wafer chuck 14 thus maintaining the edge ring 18 in a desired position with respect to the wafer 19. As shown, the edge ring 18 rests on a coupling ring assembly which comprises a coupling ring 15 and an electrostatic edge ring chuck 17 secured to an upper surface thereof. The edge ring chuck 17 can extend completely across the coupling ring 15 or the edge ring chuck 17 can be located in a recess in the upper surface of the coupling ring 15. The coupling ring 15 can be supported on the base plate 13 with or without mechanical or adhesive fastening such as a plurality of bolts 24. The edge ring chuck 17 can be supplied with DC power by a suitable power supply arrangement such as a DC power supply 26 using a lead wire 28 extending through a passage in one of the bolts 24. In order to improve thermal transfer between the edge ring 15 and the base plate 13, a heat transfer gas such as He or process gas from a gas source 30 can be supplied via gas passage 32 to the interface between the coupling ring 15 and the base plate 13 and/or between the edge ring chuck 17 and the edge ring 18. The gas passage 32 can extend through the base plate 13 and coupling ring 15 at one or more locations spaced around the base plate 13, e.g., extending through passages in the bolts 28. The edge ring chuck 17 can be a mono-polar or bi-polar chuck.

FIGURES 3-5 show variations of another embodiment of the present invention wherein the edge ring chuck is mounted on the base plate rather than on a coupling ring. As shown in FIGURE 3, an edge ring chuck is supported on the baseplate 32 and a wafer chuck 36 supports a wafer 38. To promote heat transfer, a gas supply 30 can supply a heat transfer gas through gas passage 32 into an interface between the edge ring chuck 34 and the edge ring 30.

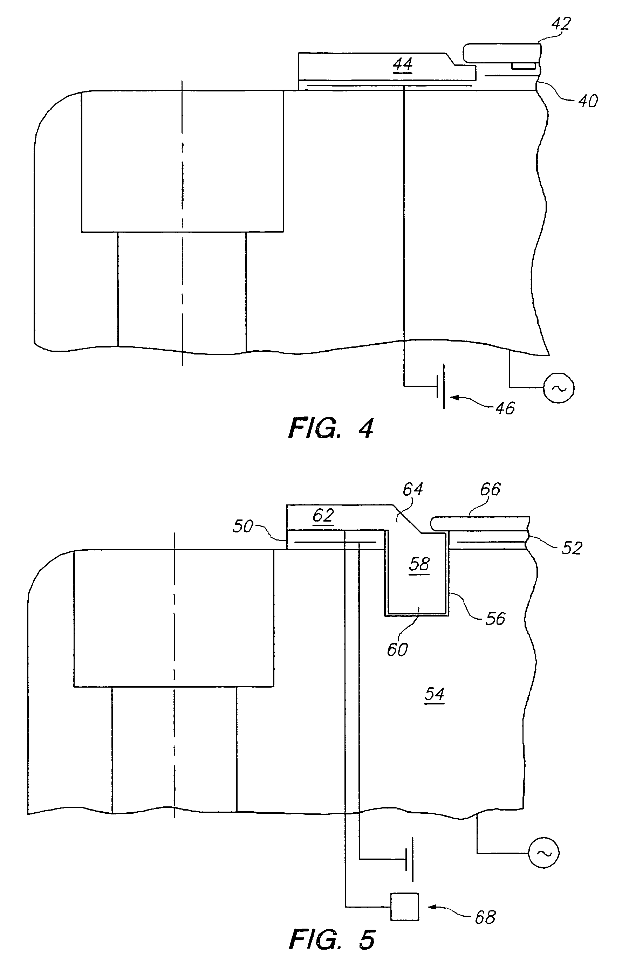

FIGURE 4 shows another embodiment of the plasma chamber of the invention comprising an integral (one-piece) wafer and edge ring chuck. As shown, a peripheral portion of the upper surface of the integral wafer/edge ring 40 chuck is recessed to allow a wafer 42 mounted on a central portion of the chuck to overlap an edge ring 44 mounted on the peripheral portion of the chuck. The electrode of the edge ring chuck is shown powered by a DC power supply 46. The internal electrode (mono-polar) or electrodes (bi-polar) of the edge ring portion of the chuck are preferably electrically isolated from the internal electrode or electrodes of the wafer portion of the chuck.

FIGURE 5 shows another embodiment of the plasma chamber of the present invention wherein the edge ring chuck 50 and the wafer chuck 52 are mounted directly on baseplate 54 such that the upper surfaces of the edge ring and wafer chucks 50, 52 are approximately coplanar. A groove 56 on baseplate 54 separates the edge ring and wafer chucks 50, 52. The edge ring 58 has an axially extending portion 60 configured to engage the groove in the baseplate 56 and a radially extending portion 62. A lower surface of the radially extending portion 62 rests on the edge ring chuck 50. The axially extending portion of the edge ring 60 is sized to allow for expansion of the edge ring during processing. The axially and radially extending portions of the edge ring 60, 62 are connected by a transition portion 64 which is configured to allow a wafer 66 to overlap an inner surface of the edge ring 58. As with the other embodiments, the underside of the edge ring 58 is supplied with a heat transfer gas 68. The interfaces between the axially extending portion of the edge ring 60 and the groove in the baseplate 56 can also be provided with heat transfer gas to further improve thermal coupling of the baseplate and edge ring.

Better temperature control of the edge ring results in numerous process advantages. First, controlling the temperature of the edge ring reduces the amount of thermal expansion of the edge ring and thus allows for smaller clearances between the top of the edge ring and the underside of the wafer. For example, when the edge ring merely rests on the underlying coupling ring or substrate support, the clearance between the backside of the wafer and the edge ring is typically in the range of 0.127 or 0.152mm (0.005 or 0.006 inches). With an electrostatically clamped edge ring, however, this clearance can be reduced to 0.0508 to 0.0762mm (0.002 to 0.003 inches). By reducing the clearance between the edge ring and the wafer, the edge of the wafer chuck is protected to a greater degree from erosion by the plasma. Further, the tendency of particles generated during plasma processing to build up on the edge of the chuck is reduced. Particle build-up can prevent the wafer from uniformly contacting the wafer chuck resulting in diminished clamping capacity. Reducing the temperature of the edge ring can also increase the longevity of the edge ring since the chemical reaction rates of the edge ring material with the ions in the plasma will be lower at lower temperatures.

Using an electrostatic chuck to clamp the edge ring can also lead to improvements in wafer etch characteristics. Improvements in etch uniformity can result from both matching the temperature of the wafer and edge ring as well as from matching the RF impedance path through the wafer and the edge ring. First, if the wafer and edge ring are similar in temperature during processing, the etch characteristics can be made more uniform near the edge of the wafer. Second, by using an edge ring chuck made of the same materials as the wafer chuck, the impedance path from the RF powered base plate through the hot edge ring can be made more similar to the impedance path from the RF powered base plate through the wafer. This is particularly true when the wafer and edge ring are made from the same material (e.g., silicon). The current density in the plasma region adjacent the wafer and edge ring surfaces is influenced by the RF impedance of these surfaces. By matching the RF impedance of the edge ring and wafer, the current flow from the plasma to the wafer surface can be made more uniform near the edge of the wafer thus improving the plasma uniformity and etch performance of the reactor.

Electrostatically clamping the edge ring can also result in reduced costs of operating plasma processing equipment when compared to other methods of securing the edge ring such as adhesive bonding or mechanical fastening. For example, since there is no need to bond the edge ring to another member, the cost of the consumable edge ring can be reduced. Also, with electrostatic clamping, the edge ring has no exposed screw heads that are covered in a separate step prior to operating the equipment.

The edge ring can be made from any conductive material including, but not limited to, silicon, silicon nitride, silicon carbide and aluminum nitride. The edge ring material is preferably the same as the wafer material in order to improve RF coupling uniformity.

The edge ring chuck can be made from any suitable material such as those used in conventional electrostatic wafer chucks including anodized aluminum, polyimides and ceramic materials. The edge ring chuck is preferably made from a ceramic material such as alumina or aluminum nitride. The electrode or electrodes of the edge ring chuck can be made from any suitable conductive material. With sintered ceramic chucks, the electrodes are preferably made from a refractory metal such as tungsten or molybdenum which can withstand the high temperatures encountered during sintering. The edge ring chuck can be made by a sintering process such as sandwiching a refractory metal electrode (tungsten ink) between two ceramic green sheets and firing to form the sintered structure. The edge ring chuck can be of the coulombic (fully insulating) or Johnsen-Rahbeck type (semiconducting).

The edge ring chuck may be secured to the coupling ring or substrate support using any of the methods and materials known in the art for securing wafer chucks. The edge ring chuck, for example, may be secured using a high temperature polymer adhesive such as a silicone adhesive.

Although the present invention has been described in connection with preferred embodiments thereof, it will be appreciated by those skilled in the art that additions, deletions, modifications, and substitutions not specifically described can be made without departing from the scope of the invention as defined in the appended claims.

## Claims

1. A coupling ring assembly adapted to surround a substrate support in a plasma reaction chamber, said coupling ring assembly comprising:
a member having an annular support surface;
an electrostatic ring chuck on the support surface; and
an edge ring on the electrostatic ring chuck dimensioned so as to provide a clearance gap between a lower surface of a substrate located on the substrate support and an upper surface of the edge ring.

2. A coupling ring assembly according to claim 1, wherein the electrostatic ring chuck comprises an outer portion of a ceramic body mounted on the substrate support, including an electrostatic substrate chuck located radially inward of the electrostatic ring chuck.

3. A coupling ring assembly according to claim 1, wherein a groove is located in the annular support surface, the groove being adapted to receive an extended portion of the edge ring clamped on the electrostatic ring chuck.

4. A coupling ring assembly according to claim 1, further comprising at least one gas passage extending through the member and the electrostatic ring chuck, the gas passage being adapted to supply a heat transfer gas to an exposed surface of the electrostatic ring chuck.

5. A coupling ring assembly according to claim 1, wherein the electrostatic ring chuck is a bipolar chuck.

6. A plasma reaction chamber, comprising:
an edge ring clamping assembly adapted to surround a substrate support in the plasma reaction chamber, the edge ring clamping assembly comprising:
a member having an annular support surface;
an electrostatic edge ring chuck on the annular support surface; and
an edge ring on the edge ring chuck dimensioned so as to provide a clearance gap between a lower surface of a substrate located on the substrate support and an upper surface of the edge ring.

7. A plasma chamber according to claim 6, wherein the substrate support comprises a baseplate having an electrostatic substrate chuck on an upper surface thereof.

8. A plasma chamber according to claim 7, wherein an upper surface of the substrate chuck is higher in a vertical direction with respect to an upper surface of the edge ring chuck.

9. A plasma chamber according to claim 7, wherein the substrate support includes a groove between the electrostatic substrate chuck and the electrostatic edge ring chuck, the groove being adapted to receive an extended portion of the edge ring clamped on the electrostatic edge ring chuck.

10. A plasma chamber according to claim 6, wherein the edge ring is adapted to be electrostatically clamped to the electrostatic edge ring chuck.

11. A plasma chamber according to claim 6, wherein the edge ring is comprised entirely of an electrically conductive material selected from silicon and silicon carbide.

12. A plasma chamber according to claim 10, wherein the substrate support includes an annular flange and a coupling ring mounted on the annular flange, the electrostatic edge ring chuck being located on an upper surface of the coupling ring, the edge ring being clamped on the coupling ring such that a recess in an upper surface of the edge ring is located beneath an outer periphery of a substrate mounted on the electrostatic substrate chuck.

13. A plasma chamber according to claim 7, wherein the baseplate comprises an electrically conductive material.

14. A plasma chamber according to claim 13, wherein the baseplate is an RF driven electrode.

15. A plasma chamber according to claim 14, wherein the plasma reaction chamber comprises a parallel plate reactor having an upper electrode facing the baseplate.

16. A plasma chamber according to claim 15, further comprising a substrate mounted on the electrostatic substrate chuck such that the outer edge of the substrate overhangs the edge ring with a clearance gap of 0.0508 mm (0.002 inches) to 0.0762 mm (0.003 inches) between the lower surface of the substrate and an upper surface of the edge ring.

17. A plasma chamber according to claim 6, wherein the plasma chamber is a semiconductor etching apparatus.

18. A plasma chamber according to claim 6, wherein the edge ring is temperature controlled.

19. A plasma chamber according to claim 18, further comprising a gas source for supplying a heat transfer gas via a gas passage to an interface between the electrostatic edge ring chuck and the edge ring.

20. A method of treating a semiconductor substrate in the plasma chamber of claim 7, said method comprising the steps of:
electrostatically clamping a substrate to the substrate chuck;
electrostatically clamping the edge ring to the edge ring chuck;
supplying a process gas to the interior of the plasma chamber;
energizing the process gas into a plasma state; and
processing the wafer with the plasma.

21. A method according to claim 20, further comprising controlling the temperature of the edge ring by supplying a heat transfer gas between opposed surfaces of the edge ring and the annular support.

## Patentansprüche

1. Kopplungsringanordnung, die geeignet ist, einen Substratträger in einer Plasmareaktionskammer zu umschließen, wobei die Kopplungsringanordnung Folgendes umfasst:
ein Element mit einer ringförmigen Trägerfläche;
ein elektrostatisches Ringfutter auf der Trägerfläche; und
einen Randring auf dem elektrostatischen Ringfutter, der so dimensioniert ist, dass er einen freien Abstand zwischen einer unteren Oberfläche eines Substrats auf dem Substratträger und einer oberen Oberfläche des Randrings schafft.

2. Kopplungsringanordnung gemäß Anspruch 1, wobei das elektrostatische Ringfutter einen äußeren Abschnitt eines auf dem Substratträger montierten keramischen Körpers umfasst, einschließlich eines elektrostatischen Substratfutters, das radial einwärts des elektrostatischen Ringfutters angeordnet ist.

3. Kopplungsringanordnung gemäß Anspruch 1, wobei in der ringförmigen Trägerfläche eine Nut angeordnet ist, die geeignet ist, einen erweiterten Teil des an das elektrostatische Ringfutter geklemmten Randrings aufzunehmen.

4. Kopplungsringanordnung gemäß Anspruch 1, die des weiteren mindestens einen Gaskanal aufweist, der sich durch das Element und das elektrostatische Ringfutter erstreckt, wobei der Gaskanal geeignet ist, einer exponierten Oberfläche des elektrostatischen Ringfutters ein Wärmeübertragungsgas zuzuführen.

5. Kopplungsringanordnung gemäß Anspruch 1, wobei das elektrostatische Ringfutter ein bipolares Futter ist.

6. Plasmareaktionskammer, die Folgendes umfasst:
eine Randringklemmanordnung, die geeignet ist, einen Substratträger in der Plasmareaktionskammer zu umschließen, wobei die Randringklemmanordnung Folgendes umfasst:
ein Element mit einer ringförmigen Trägerfläche;
ein elektrostatisches Randringfutter auf der ringförmigen Trägerfläche; und
einen Randring auf dem Randringfutter, der so dimensioniert ist, dass er einen Abstand zwischen einer unteren Oberfläche eines auf dem Substratträger angeordneten Substrats und einer oberen Oberfläche des Randrings schafft.

7. Plasmakammer gemäß Anspruch 6, wobei der Substratträger eine Basisplatte mit einem elektrostatischen Substratfutter auf einer oberen Oberfläche derselben umfasst.

8. Plasmakammer gemäß Anspruch 7, wobei eine obere Oberfläche des Substratfutters in vertikaler Richtung mit Bezug auf eine obere Oberfläche des Randringfutters höher ist.

9. Plasmakammer gemäß Anspruch 7, wobei der Substratträger eine Nut zwischen dem elektrostatischen Substratfutter und dem elektrostatischen Randringfutter umfasst, wobei die Nut geeignet ist, einen erweiterten Teil des an das elektrostatische Randringfutter geklemmten Randrings aufzunehmen.

10. Plasmakammer gemäß Anspruch 6, wobei der Randring geeignet ist, elektrostatisch an das elektrostatische Randringfutter geklemmt zu werden.

11. Plasmakammer gemäß Anspruch 6, wobei der Randring vollständig aus einem elektrisch leitenden Material besteht, das aus Silicium und Siliciumcarbid ausgewählt ist.

12. Plasmakammer gemäß Anspruch 10, wobei der Substratträger einen ringförmigen Flansch und einen an dem ringförmigen Flansch montierten Kopplungsring umfasst, wobei das elektrostatische Randringfutter auf einer oberen Oberfläche des Kopplungsrings angeordnet ist und der Randring so an den Kopplungsring geklemmt ist, dass eine Vertiefung in einer oberen Oberfläche des Randrings unterhalb einer äußeren Peripherie eines am elektrostatischen Substratfutter montierten Substrats vorgesehen ist.

13. Plasmakammer gemäß Anspruch 7, wobei die Basisplatte ein elektrisch leitendes Material umfasst.

14. Plasmakammer gemäß Anspruch 13, wobei die Basisplatte eine HFgesteuerte Elektrode ist.

15. Plasmakammer gemäß Anspruch 14, wobei die Plasmareaktionskammer einen parallelen Plattenreaktor mit einer oberen Elektrode umfasst, die der Basisplatte zugewandt ist.

16. Plasmakammer gemäß Anspruch 15, die des weiteren ein Substrat umfasst, das so am elektrostatischen Substratfutter montiert ist, dass der Außenrand des Substrats den Randring mit einem freien Abstand von 0,0508 mm (0,002 Inch) bis 0,0762 mm (0,003 Inch) zwischen der unteren Oberfläche des Substrats und der oberen Oberfläche des Randrings übersteht.

17. Plasmakammer gemäß Anspruch 6, wobei die Plasmakammer eine Halbleiter-Ätzvorrichtung ist.

18. Plasmakammer gemäß Anspruch 6, wobei der Randring Temperatur-geregelt ist.

19. Plasmakammer gemäß Anspruch 18, die des weiteren eine Gasquelle zur Zuführung eines Wärmeübertragungsgases über einen Gaskanal auf eine Grenzfläche zwischen dem elektrostatischen Randringfutter und dem Randring umfasst.

20. Verfahren zur Bearbeitung eines Halbleitersubstrats in der Plasmakammer gemäß Anspruch 7, wobei das Verfahren folgende Schritte umfasst:
elektrostatisches Festklemmen eines Substrats am Substratfutter;
elektrostatisches Festklemmen des Randrings am Randringfutter;
Zuführung eines Prozessgases in das Innere der Plasmakammer;
Erregung des Prozessgases in einen Plasmazustand; und
Bearbeitung des Wafers mit dem Plasma.

21. Verfahren gemäß Anspruch 20, das des weiteren die Regelung der Temperatur des Randrings durch die Zuführung eines Wärmeübertragungsgases zwischen einander gegenüber angeordneten Oberflächen des Randrings und dem ringförmigen Träger umfasst.

## Revendications

1. Ensemble d'anneau de couplage adapté pour entourer un support de substrat dans une chambre de réaction à plasma, ledit ensemble d'anneau de couplage comprenant :
un élément présentant une surface de support annulaire ;
un mandrin de serrage d'anneau électrostatique sur la surface du support ; et
un anneau de bordure sur le mandrin de serrage d'anneau électrostatique dimensionné de façon à fournir un intervalle d'espacement entre une surface inférieure d'un substrat placé sur le support de substrat et une surface supérieure de l'anneau de bordure.

2. Ensemble d'anneau de couplage selon la revendication 1, dans lequel le mandrin de serrage d'anneau électrostatique comporte une partie extérieure constituée d'un corps en céramique monté sur le support de substrat, incluant un mandrin de serrage de substrat électrostatique placé radialement vers l'intérieur du mandrin de serrage d'anneau électrostatique.

3. Ensemble d'anneau de couplage selon la revendication 1, dans lequel une gorge est située dans la surface de support annulaire, la gorge étant adaptée pour recevoir une partie de prolongement de l'anneau de bordure bloqué sur le mandrin de serrage d'anneau électrostatique.

4. Ensemble d'anneau de couplage selon la revendication 1, comportant, de plus, au moins un passage pour un gaz s'étendant à travers l'élément et le mandrin de serrage d'anneau électrostatique, le passage pour un gaz étant adapté pour fournir un gaz de transfert thermique à une surface exposée du mandrin de serrage d'anneau électrostatique.

5. Ensemble d'anneau de couplage selon la revendication 1, dans lequel le mandrin de serrage d'anneau électrostatique est un mandrin de serrage bipolaire.

6. Chambre de réaction à plasma, comportant :
un ensemble de blocage d'anneau de bordure adapté pour entourer un support de substrat dans la chambre de réaction à plasma, l'ensemble de blocage d'anneau de bordure comprenant :
un élément présentant une surface de support annulaire ;
un mandrin de serrage d'anneau de bordure électrostatique sur la surface de support annulaire ; et
un anneau de bordure sur le mandrin de serrage d'anneau de bordure dimensionné de façon à fournir un intervalle d'espacement entre une surface inférieure d'un substrat placé sur le support de substrat et une surface supérieure de l'anneau de bordure.

7. Chambre de plasma selon la revendication 6, dans laquelle le support de substrat comprend une plaque de base comportant un mandrin de serrage de substrat électrostatique sur sa surface supérieure.

8. Chambre à plasma selon la revendication 7, dans laquelle une surface supérieure du mandrin de serrage de substrat est plus élevée dans une direction verticale par rapport à une surface supérieure du mandrin de serrage d'anneau de bordure.

9. Chambre à plasma selon la revendication 7, dans laquelle le support de substrat comporte une gorge située entre le mandrin de serrage de substrat électrostatique et le mandrin de serrage d'anneau de bordure électrostatique, la gorge étant adaptée pour recevoir une partie de prolongement de l'anneau de bordure bloquée sur le mandrin de serrage d'anneau de bordure électrostatique.

10. Chambre à plasma selon la revendication 6, dans lequel l'anneau de bordure est adapté pour être bloqué de façon électrostatique sur le mandrin de serrage d'anneau de bordure électrostatique.

11. Chambre à plasma selon la revendication 6, dans laquelle l'anneau de bordure est composé entièrement d'un matériau conducteur électriquement sélectionné à partir du silicium et du carbure de silicium.

12. Chambre à plasma selon la revendication 10, dans laquelle le support de substrat comprend une bride annulaire et un anneau de couplage fixé sur la bride annulaire, le mandrin de serrage d'anneau de bordure électrostatique étant placé sur une surface supérieure de l'anneau de couplage, l'anneau de bordure étant bloqué sur l'anneau de couplage de telle façon qu'un évidement formé dans une surface supérieure de l'anneau de bordure se trouve placé au-dessous d'une périphérie extérieure d'un substrat monté sur le mandrin de serrage de substrat électrostatique.

13. Chambre à plasma selon la revendication 7, dans laquelle la plaque de base comporte un matériau électriquement conducteur.

14. Chambre à plasma selon la revendication 13, dans laquelle la plaque de base est une électrode commandée par RF.

15. Chambre à plasma selon la revendication 14, dans laquelle la chambre de réaction à plasma comprend un réacteur à plaques parallèles comportant une électrode supérieure faisant face à la plaque de base.

16. Chambre à plasma selon la revendication 15 comportant, de plus, un substrat monté sur le mandrin de serrage de substrat électrostatique de telle sorte que la bordure extérieure du substrat surplombe l'anneau de bordure avec un intervalle d'espacement de 0,0508 mm (0,002 pouce) à 0,0762 mm (0,003 pouce) entre la surface inférieure du substrat et une surface supérieure de l'anneau de bordure.

17. Chambre à plasma selon la revendication 6, dans laquelle la chambre à plasma est un appareil de gravure de semi-conducteurs.

18. Chambre de plasma selon la revendication 6, dans laquelle l'anneau de bordure est contrôlé en température.

19. Chambre à plasma selon la revendication 18, comprenant, de plus, une source de gaz pour fournir un gaz de transfert thermique via un passage pour le gaz à une interface entre le mandrin de serrage d'anneau de bordure électrostatique et l'anneau de bordure.

20. Procédé de traitement d'un substrat semi-conducteur dans la chambre à plasma selon la revendication 7, ledit procédé comportant les étapes consistant à :
bloquer de façon électrostatique un substrat sur le mandrin de serrage de substrat ;
bloquer de façon électrostatique l'anneau de bordure sur le mandrin de serrage d'anneau de bordure ;
fournir un gaz de process à l'intérieur de la chambre à plasma ;
activer le gaz de process à l'état de plasma ; et
traiter la plaquette avec le plasma.

21. Procédé selon la revendication 20, comprenant, de plus, une commande de la température de l'anneau de bordure en fournissant un gaz de transfert thermique entre des surfaces opposées de l'anneau de bordure et du support annulaire.
